# EUROPÄISCHE PATENTSCHRIFT

(11) **EP 3 692 581 B1**
(45) Veröffentlichungstag und Bekanntmachung des Hinweises auf die Patenterteilung: **01.06.2022**
(21) Anmeldenummer: 18810903.7
(22) Anmeldetag: 14.11.2018
(51) Int. Cl.: F15B 21/06, H01H 33/666, H01H 3/24, H02N 2/04

(54) **AKTUATOR BESTEHEND AUS FESTKÖRPERAKTUATOR UND HYDRAULIK EINHEIT UND VERFAHREN ZUM SCHALTEN**
ACTUATOR COMPRISING SOLID STATE ACTUATOR AND HYDRAULIC UNIT AND METHOD OF SWITCHING
DISPOSITIF D'ACTIONNEMENT POURVU D'ACTIONNEUR DE CORPS FIXE ET D'UNITÉ HYDRAULIQUE ET PROCÉDÉ DE COMMUTATION

(30) Priorität: 27.11.2017 EP 17203689
(43) Veröffentlichungstag der Anmeldung: 12.08.2020
(73) Patentinhaber: Siemens Aktiengesellschaft, 80333 München (DE)
(72) Erfinder: BACHMAIER, Georg, 80469 München (DE); GERLICH, Matthias, 80636 München (DE); KNABE, Thomas, 12307 Berlin (DE); LAST, Philipp, 12161 Berlin (DE); ZÖLS, Wolfgang, 81249 München-Lochhausen (DE)
(86) Internationale Anmeldenummer: PCT/EP2018/081260
(87) Internationale Veröffentlichungsnummer: WO 2019/101603

(56) Entgegenhaltungen:
- WO-A1-2016/050490
- DE-A1- 10 017 178
- US-A1- 2015 345 519

## Beschreibung

Die Erfindung betrifft eine Schalteinrichtung sowie ein Verfahren zum Schalten eines elektrischen Schalters oder Schaltgeräts.

In elektrischen Energienetzen kommen zum Schutz von Netzkomponenten oder von mit Energie zu versorgenden Geräten, Maschinen und Anlagen unterschiedliche Schalteinrichtungen zum Einsatz. Solche Schalteinrichtungen werden bei Nieder,- Mittel- und Hochspannungsnetzen und dort jeweils sowohl für Gleich- und Wechselspannung eingesetzt. Beispiele aus dem Stand der Technik lassen sich in Patentschriften WO2016/050490 und CN104343928 finden.

Derartige Schalteinrichtungen sind dazu ausgelegt, bei einem Schaltvorgang zwei elektrische Schaltkontakte entweder zu öffnen, d.h. auseinander zu bewegen, oder zu schließen, d.h. miteinander in elektrisch leitenden Kontakt zu bringen. Dazu sind die elektrischen Schaltkontakte häufig sehr schnell zu bewegen. Zu diesem Zweck sind geeignete Antriebskonzepte erforderlich.

Es sind Schalteinrichtungen bekannt, bei denen ein elektrischer Schaltkontakt formschlüssig festgelegt ist und mittels elektromagnetischer Auslöser freigegeben werden kann. Die Schaltzeiten solcher Schalteinrichtungen sind jedoch limitiert, was einen Einsatz in speziellen Anwendungen wie insbesondere dem Kurzschließen und/oder dem Strombegrenzen einschränkt.

Für besonders kurze Schaltzeiten im Bereich von weniger als 5 Mikrosekunden sind Explosionsantriebe, etwa von ABB, bekannt, bei welchen Schaltvorgänge mittels Explosion antreibbar sind oder leitende Verbindungen mittels Explosion aufsprengbar sind, so dass ein elektrischer Kontakt unterbrochen werden kann. Solche Lösungen sind jedoch typischerweise nur ein einziges Mal nutzbar.

Es ist vor diesem Hintergrund Aufgabe der vorliegenden Erfindung, eine verbesserte Schalteinrichtung zu schaffen, mittels welcher möglichst rasch geschaltet werden kann. Vorzugsweise soll zudem mit möglichst hoher Schaltkraft geschaltet werden können. Insbesondere soll eine Schalteinrichtung geschaffen werden, die wiederholt nutzbar ist.

Diese Aufgaben werden mit einer Schalteinrichtung mit den in Anspruch 1 angegebenen Merkmalen sowie mit einem Verfahren zum Schalten eines Schalters mit den in Anspruch 15 angegebenen Merkmalen gelöst. Vorteilhafte Weiterbildungen der Erfindung sind in den zugehörigen Unteransprüchen, der nachfolgenden Beschreibung und der Zeichnung angegeben. Dabei können die beschriebenen Ausgestaltungen der Schalteinrichtung und des Verfahrens zum Schalten eines elektrischen Schalters vorteilhaft miteinander kombiniert werden.

Die erfindungsgemäße Schalteinrichtung umfasst mindestens einen elektrischen Schaltkontakt sowie eine zur Arretierung ausgebildete Aktoreinrichtung, welche einen Festkörperaktor und eine zu dem Festkörperaktor mechanisch in Serie geschaltete Hydraulikeinheit aufweist. Dabei weist die Hydraulikeinheit der erfindungsgemäßen Schalteinrichtung ein Hydraulikvolumen auf, welches mit einer Hydraulikflüssigkeit befüllbar und vorzugsweise befüllt ist. Die erfindungsgemäße Schalteinrichtung umfasst zudem einen Arretierkörper, welcher mit der Aktoreinrichtung arretierbar ist und welcher mit dem mindestens einen elektrischen Schaltkontakt bewegungsgekoppelt ist. Der Arretierkörper ist ein Klemmkörper, welcher mittels der Hydraulikeinheit klemmbar ist und/oder ein welcher mittels der Hydraulikeinheit formschlüssig festlegbar Formschlusskörper, ist. Geeigneterweise ist bei der erfindungsgemäßen Schalteinrichtung der Arretierkörper arretierbar und entriegelbar.

Das Hydraulikvolumen kann insbesondere im Wesentlichen vollständig mit der Hydraulikflüssigkeit befüllt sein. Vorzugsweise sollte Hydraulikflüssigkeit das Hydraulikvolumen so weit ausfüllen, dass durch diese Hydraulikflüssigkeit eine Übertragung von Kraft und/oder mechanischer Bewegungsenergie zwischen verschiedenen Elementen der Hydraulikeinheit (insbesondere zwischen einem Antriebselement und einem Abtriebselement) ermöglicht wird.

Unter dem genannten Merkmal, dass der Festkörperaktor mit der Hydraulikeinheit *"mechanisch in Serie geschaltet"* ist, soll im vorliegenden Zusammenhang verstanden werden, dass Festkörperaktor und Hydraulikeinheit so verbunden sind, dass eine mechanische Bewegung eines Teils des Festkörperaktors auf einen korrespondierenden Teil der Hydraulikeinheit übertragbar ist. Die Hydraulikeinheit ist insbesondere dazu ausgestaltet, diese Bewegung des korrespondierenden Teils der Hydraulikeinrichtung auf ein, insbesondere äußeres, zu bewegendes Element zu übertragen, wobei eine solche Übertragung allgemein mit einem bestimmten Übersetzungsverhältnis und/oder mit einer Integration von mehreren Einzelbewegungen verbunden sein kann. Dieses Element weist eine Klemmfläche zur Klemmung des Arretierkörpers in Gestalt eines Klemmkörpers und/oder einen Vorsprung zur Verriegelung, d.h. zur formschlüssigen Festlegung, des Arretierkörpers in Gestalt eines Formschlusskörpers auf. D.h. unter einer Arretierung im Sinne der vorliegenden Erfindung ist vorzugsweise eine Klemmung zu verstehen, wobei mittels der Aktoreinrichtung eine Arretierkörper in Gestalt eines Klemmkörpers festlegbar ist. Alternativ oder zusätzlich kann unter einer Arretierung im Sinne dieser Erfindung eine formschlüssige Arretierung, also eine Verriegelung, zu verstehen sein, wobei der Arretierkörper mittels der Hydraulikeinheit und vorzugsweise dem, insbesondere zusätzlichen, Element, formschlüssig festlegbar ist und somit einen Formschlusskörper ausbildet.

Geeigneterweise umfasst der Formschlusskörper eine Ausnehmung und das Element einen mit der Ausnehmung korrespondierenden Vorsprung. Alternativ und ebenfalls bevorzugt umfasst das Element eine Ausnehmung und der Formschlusskörper einen mit der Ausnehmung korrespondierenden Vorsprung. Zweckmäßig bildet dieses weitere Element mit der Klemmfläche zusammen mit der Hydraulikeinheit und dem Festkörperaktor die Aktoreinrichtung der erfindungsgemäßen Schalteinrichtung. Dieses Element kann Bestandteil der Hydraulikeinheit sein oder ein zusätzliches, d.h. "äußeres" Element sein, welches mit der Hydraulikeinheit mechanisch in Serie geschaltet ist. Vorzugsweise ist dieses Element Bestandteil der erfindungsgemäßen Aktoreinrichtung.

Vorteilhaft weisen Festkörperaktoren, wie sie bei der erfindungsgemäßen Schalteinrichtung vorgesehen sind, hohe mechanische Eigenfrequenzen und damit kurze Stellzeiten mit zugleich hohen Stellkräften auf. Insbesondere können die Auslenkzeiten solcher Festkörperaktoren mindestens 20 Mikrosekunden und/oder höchstens 20 Millisekunden, vorzugsweise höchstens 200 Mikrosekunden und idealerweise höchstens 50 Mikrosekunden, betragen. Mittels der bei der erfindungsgemäßen Schalteinrichtung vorgesehenen, in Serie geschalteten, Hydraulikeinheit ist zudem eine Auslenkung des Festkörperaktors besonders verzögerungsarm und nahezu verlustfrei übertragbar, sodass mittels der Schalteinrichtung eine nahezu instantane Arretierung des Arretierkörpers infolge einer Ansteuerung des Festkörperaktors bewirkbar ist. Folglich kann der Arretierkörper ohne deutlichen Verzug entweder freigegeben werden oder an seiner Bewegung gehindert werden. Somit kann mittels der erfindungsgemäßen Schalteinrichtung besonders rasch geschaltet werden.

Vorteilhaft ist die erfindungsgemäße Schalteinrichtung zerstörungsfrei nutzbar. Insbesondere im Vergleich zu Explosionsantrieben ist die erfindungsgemäße Schalteinrichtung daher nicht nur einmalig, sondern wiederholt nutzbar. Denn die erfindungsgemäße Schalteinrichtung lässt in den ursprünglichen Zustand zurück versetzen, sodass die Schalteinrichtung erneut einsetzbar ist. Weiterhin vorteilhaft lässt sich die erfindungsgemäße Schalteinrichtung aufgrund des Verzichts auf Explosionsantriebe ohne Schaden für ggf. vorhandene Periphäreinrichtungen und somit besonders betriebssicher einsetzen. Aufgrund der erfindungsgemäß vorgesehenen Hydraulikeinheit ist die erfindungsgemäße Schalteinrichtung zudem mechanisch verschleißarm ausgebildet.

In einer bevorzugten Weiterbildung der Erfindung weist die Schalteinrichtung ein Federelement und/oder Antriebselement auf, welches zur Kraftbeaufschlagung des Arretierkörpers und/oder zum Antrieb des Arretierkörpers, insbesondere an dem Arretierkörper, angeordnet und ausgebildet ist. Auf diese Weise ist der Arretierkörper mit einer hohen Kraft beaufschlagbar, welche den Arretierkörper beschleunigen kann, sofern er nicht arretiert ist. Wenn die erfindungsgemäß vorgesehene Aktoreinrichtung den Arretierkörper arretiert und somit in der Bewegung festlegt, lassen sich mittels der erfindungsgemäßen Schalteinrichtung Bewegungen des Arretierkörpers und somit des elektrischen Schaltkontakts rasch einleiten und/oder unterbinden.

Zweckmäßig weist bei der erfindungsgemäßen Schalteinrichtung das Federelement oder Antriebselement einen Druckspeicher und/oder einen Magneten und/oder eine Feder auf. Mittels eines Druckspeichers und/oder eines Magneten oder mittels Federn lässt sich der Arretierkörper vorteilhaft auf konstruktiv einfache Weise mit einer hohen Kraft beaufschlagen. Geeigneterweise weist bei der erfindungsgemäßen Schalteinrichtung die Aktoreinrichtung mindestens eine Klemmfläche auf, die zur reibschlüssigen Ineingriffnahme des Arretierkörpers in Gestalt eines Klemmkörperss ausgebildet ist. In dieser Weiterbildung der Erfindung lässt sich der Klemmkörper leicht durch Kraftbeaufschlagung in Richtung schräg, insbesondere senkrecht, zu einer vorgegebenen Bewegungsrichtung des Klemmkörpers in seiner Bewegung festlegen. Es versteht sich, dass die Bewegung des Arretierkörpers keine Schwerpunktsbewegung des Arretierkörper sein muss. Es ist grundsätzlich ebenfalls ausreichend und möglich, dass eine Oberfläche des Arretierkörpers beweglich und durch Arretierung, d.h. durch Klemmung und/oder Formschluss, festlegbar ist, etwa im Falle einer bloßen Rotation des Arretierkörper, welche gerade keine Schwerpunktsbewegung des Arretierkörpers umfasst.

Bei der Schalteinrichtung gemäß der Erfindung ist im Falle der Arretierung in Form einer Klemmung vorzugsweise die Aktoreinrichtung ausgebildet, den Arretierkörper in Gestalt eines Klemmkörpers umfänglich, vorzugsweise vollumfänglich, zu klemmen. Mittels einer umfänglichen Klemmung des Klemmkörpers ist eine große Kontaktfläche zur reibschlüssigen Festlegung des Klemmkörpers nutzbar. Folglich sind in dieser Weiterbildung der Erfindung besonders große Klemmkräfte auf den Klemmkörper realisierbar. Vorzugsweise ist der Klemmkörper außenumfänglich klemmbar. Alternativ oder zusätzlich und ebenfalls bevorzugt kann der Klemmkörper auch innenumfänglich klemmbar, insbesondere innenumfänglich an einem Innenumfang eines als Hohlwelle oder Hohlzylinder ausgebildeten Klemmkörpers, klemmbar ausgebildet sein.

Bevorzugt weist der Arretierkörper eine, abgesehen von zum Formschluss ggf. vorgesehener Ausnehmungen und/oder Vorsprünge, zylindrische, vorzugsweise kreiszylindrische, Form auf und bildet geeigneterweise eine Welle. Soweit in dieser Anmeldung von Welle die Rede ist, kann der Begriff der Welle in einer bevorzugten Weiterbildung der Erfindung auch durch Achse und/oder Anker und/oder Stößel ersetzt werden. Alternativ oder zusätzlich weist der Arretierkörper einen polygonförmigen Querschnitt auf. Zweckmäßig weist im Falle der Arretierung in Form der Klemmung die Klemmfläche eine zum Klemmkörper ganz oder zumindest teilweise korrespondierende Form auf. In dieser Weiterbildung ist folglich vorteilhaft eine Klemmbuchse realisiert.

Mittels der in dieser Weiterbildung realisierten Klemmbuchse sind mit der erfindungsgemäßen Schalteinrichtung Klemmkräfte von mehreren Kilonewton erzielbar. Im Falle der Arretierung mittels Formschlusses sind ähnliche Haltekräfte erzielbar. Die Energie allerdings, welche zur Schaltung solcher Klemmkräfte erforderlich ist, beträgt lediglich etwa 1 Joule. Folglich lassen sich mittels der erfindungsgemäßen Schalteinrichtung hohe Schaltkräfte mittels besonders geringer Energien, etwa bereitgestellt mittels Batterien wie insbesondere Knopfzellen, steuern.

In einer bevorzugten Weiterbildung der Erfindung ist oder umfasst bei der erfindungsgemäßen Schalteinrichtung die Hydraulikflüssigkeit ein Flüssigmetall.

Unter einem Flüssigmetall soll hier ein Metall (also ein metallisches Element oder auch eine Legierung mehrerer metallische Elemente) verstanden werden, welches in einem Betriebszustand der Aktoreinrichtung einen flüssigen Aggregatzustand aufweist. Beispielsweise kann das Flüssigmetall bei Raumtemperatur und dem Betriebsdruck der Hydraulikeinheit in einem flüssigen Zustand vorliegen. Besonders vorteilhaft kann es auch noch bei tieferen Temperaturen als der Raumtemperatur oder der Betriebstemperatur der erfindungsgemäßen Schalteinrichtung in einem flüssigen Zustand vorliegen, dies ist jedoch für das Funktionieren der Erfindung nicht zwingend notwendig.

Ein wesentlicher Vorteil dieser Weiterbildung der erfindungsgemäßen Schalteinrichtung liegt darin, dass ein Flüssigmetall im Vergleich zu herkömmlichen Hydraulikflüssigkeiten eine deutlich geringere Kompressibilität aufweist. Hierdurch werden mechanische Verluste reduziert und der Wirkungsgrad der Aktoreinrichtung und damit der erfindungsgemäßen Schalteinrichtung im Vergleich zum Stand der Technik erhöht. Ein weiterer Vorteil der erfindungsgemäßen Schalteinrichtung liegt darin, dass der thermische Ausdehnungskoeffizient eines Flüssigmetalls allgemein deutlich geringer ist als bei herkömmlichen Hydraulikflüssigkeiten. Hierdurch werden durch Temperaturschwankungen bedingte mechanische Zustandsänderungen der Hydraulikeinheit vorteilhaft reduziert. Die Viskosität und die Dichte eines Flüssigmetalls sind zwar typischerweise höher als die einer herkömmlichen Hydraulikflüssigkeit. Die damit verbundenen Nachteile können jedoch in Kauf genommen werden, um die genannten Vorteile beim Betrieb der Schalteinrichtung zu erzielen. Insbesondere bei dem typisch relativ geringen Flüssigkeitsvolumen in der Hydraulikeinheit einer solchen Schalteinrichtung können die eintretenden Erhöhungen von Viskosität und/oder Dichte der Hydraulikflüssigkeit gut toleriert werden.

Vorteilhaft ist in dieser Weiterbildung die erfindungsgemäße Schalteinrichtung aufgrund der weitestgehend inkompressiblen Hydraulikflüssigkeit sowie aufgrund des vergleichsweise geringen thermischen Ausdehnungskoeffizienten daher äußerst robust gegenüber mechanischen Toleranzen und Temperaturausdehnungen.

Aufgrund der Ausbildbarkeit der Hydraulikeinheit mit einem geringen Volumen sowie der geringen Kompressibilität der Hydraulikflüssigkeit weist die erfindungsgemäße Schalteinrichtung in dieser Weiterbildung zudem besonders geringe Eigenfrequenzen auf, sodass Schaltzeiten von deutlich unterhalb einer Mikrosekunde möglich sind.

Die Hydraulikflüssigkeit kann vorteilhaft Gallium und/oder Indium und/oder Zinn und/oder Quecksilber umfassen. Derartige Metalle sind vorteilhaft geeignete Komponenten, um in einer metallischen Legierung einen niedrigen Schmelzpunkt zu erreichen. Besonders vorteilhaft weist die Hydraulikflüssigkeit sowohl Gallium als auch Indium und Zinn auf. Gemäß einer besonders bevorzugten Ausführungsform besteht sie sogar ausschließlich aus den drei genannten Metallen. Beispielsweise kann es sich bei der Hydraulikflüssigkeit um eine Legierung handeln, die in der Fachwelt unter dem Namen Galinstan bekannt ist. Galinstan ist eine eutektische Legierung, welche etwa 68,5 Gewichtsprozent Gallium sowie etwa 21,5 Gewichtsprozent Indium und etwa 10 Gewichtsprozent Zinn aufweist. Eine solche Legierung weist einen sehr niedrigen Schmelzpunkt von etwa -19 °C auf. Andere geeignete niedrigschmelzende Legierungen sind beispielsweise unter den Namen Indalloy 51 und Indalloy 60 von dem US-amerikanischen Unternehmen Indium Corporation in Utica, NY erhältlich. Weitere geeignete galliumbasierte Legierungen sind insbesondere diejenigen Legierungen, die in den Patentschriften US5800060B1 und US7726972B1 beschrieben sind. Sie können neben den drei genannten besonders bevorzugten Metallen auch Zusätze von anderen Metallen wie beispielsweise Zink (insbesondere zwischen etwa 2 und 10 Gewichtsprozent) umfassen.

Die beschriebenen Legierungen, welche mit Gallium und/oder Indium und/oder Zinn gebildet sind, haben den Vorteil, dass sie eine geringe Toxizität aufweisen und somit relativ unbedenklich bezüglich Gesundheits- und Umweltschädigungen sind. Quecksilber ist ebenfalls ein geeignetes Flüssigmetall oder ein geeigneter Legierungsbestandteil für niedrigschmelzende Legierungen, hat aber den grundsätzlichen Nachteil, dass es stark toxisch ist. Da das Hydraulikvolumen der Hydraulikeinheit der Schalteinrichtung jedoch prinzipiell sehr gut hermetisch gegen die äußere Umgebung abgedichtet sein kann, ist auch die Verwendung von Quecksilber oder quecksilberhaltigen Legierungen prinzipiell nicht ausgeschlossen und kann für bestimmte Anwendungen ebenfalls vorteilhaft sein.

Allgemein und unabhängig von ihrer genauen Zusammensetzung kann die Hydraulikflüssigkeit eine eutektische Legierung sein. Eine derartige Legierung ist besonders bevorzugt, da mit ihr ein wesentlich niedrigerer Schmelzpunkt erreicht werden kann als mit ihren einzelnen metallischen Komponenten.

Weiterhin ist es allgemein besonders bevorzugt, wenn die Hydraulikflüssigkeit bei Normaldruck bei einer Temperatur von 20 °C, zweckmäßig bei 0 °C, insbesondere sogar bei -10 °C und idealerweise bei -20 °C, flüssig ist. Mit anderen Worten ist das Flüssigmetall dann wenigstens bis hinunter zu der genannten Temperatur und unter Umständen sogar noch bei tieferen Temperaturen im flüssigen Zustand. Ein derart niedrigschmelzendes Flüssigmetall eignet sich besonders gut als Hydraulikflüssigkeit für die beschriebene Anwendung, selbst wenn die Betriebstemperatur der erfindungsgemäßen Schalteinrichtung deutlich oberhalb der genannten Temperatur liegt. In jedem Fall ist bei einer derart niedrigen Schmelztemperatur die Wahl der Betriebstemperatur für die erfindungsgemäße Schalteinrichtung nicht besonders stark eingeschränkt. Für den Betrieb der Schalteinrichtung ist es allgemein vorteilhaft, wenn die Betriebstemperatur nicht nur knapp, sondern deutlich oberhalb der Schmelztemperatur des verwendeten Flüssigmetalls liegt. Beispielsweise kann der Abstand zwischen Betriebstemperatur und Schmelztemperatur bei wenigstens 10 °C liegen. Ein solcher Sicherheitsabstand in der Temperatur wirkt sich beispielsweise auch günstig auf die Viskosität der Hydraulikflüssigkeit aus, da die Viskosität dann niedriger ist als in unmittelbarer Nähe des Schmelzpunkts. Alternativ oder zusätzlich und ebenfalls bevorzugt ist die Hydraulikflüssigkeit bei einer Betriebstemperatur und bei einem Betriebsdruck der Aktoreinrichtung flüssig.

Gemäß einer bevorzugten Weiterbildung der Erfindung liegt das Kompressionsmodul der Hydraulikflüssigkeit oberhalb von 10 GPa, beispielsweise zwischen 20 GPa und 60 GPa. Ein derart hohes Kompressionsmodul kann durch die Verwendung eines Flüssigmetalls leicht erreicht werden und hat zur Folge, dass die mechanischen Verluste in der Hydraulikeinheit niedrig sind und dass entsprechend der Wirkungsgrad der Schalteinrichtung hoch ist.

Gemäß einer weiteren bevorzugten Weiterbildung der Erfindung liegt der thermische Ausdehnungskoeffizient der Hydraulikflüssigkeit unterhalb von 0,001 1/K, insbesondere unterhalb von 0,00015 1/K. Ein derart niedriger thermischer Ausdehnungskoeffizient kann durch die Verwendung eines Flüssigmetalls leicht erreicht werden und hat zur Folge, dass Temperaturschwankungen beim Betrieb der Schalteinrichtung nur geringe Positionsänderungen bei den einzelnen Elementen der Hydraulikeinrichtung zur Folge haben.

Gemäß einer weiteren allgemein bevorzugten Weiterbildung der Erfindung liegt die Viskosität des Flüssigmetalls oberhalb von 0,5 mm²/s, beispielsweise zwischen 1 mm²/s und 100 mm²/s. Eine derart hohe Viskosität trägt zur Verringerung von Leckagen zwischen den einzelnen Leitungsteilen und somit zur Aufrechterhaltung der nötigen Druckgefälle bei.

Gemäß einer weiteren allgemein bevorzugten Weiterbildung der Erfindung liegt die Dichte des Flüssigmetalls unterhalb von 8 g/cm³, beispielsweise zwischen 5 g/cm³ und 7 g/cm³. Eine derart niedrige Dichte trägt zur Verringerung der Verluste in der Hydraulikeinheit und somit zu einem guten Wirkungsgrad der Schalteinrichtung bei.

Die hier genannten Materialparameter für das Flüssigmetall als Hydraulikflüssigkeit sollen jeweils für die Betriebsbedingungen der Schalteinrichtung, also für deren Betriebstemperatur und Betriebsdruck, gelten. Die Betriebstemperatur kann dabei insbesondere bei Raumtemperatur liegen und es können die Materialparameter als Parameter bei Raumtemperatur spezifiziert sein.

Das Hydraulikvolumen der Hydraulikeinrichtung, welche im Wesentlichen dem verwendeten Flüssigkeitsvolumen für das Flüssigmetall entspricht, kann allgemein bevorzugt unterhalb von 10 Millilitern liegen. Ein derart niedriges Flüssigkeitsvolumen ist allgemein vorteilhaft, um die mechanischen Verluste (insbesondere Reibungsverluste und Kompressionsverluste) der Hydraulikflüssigkeit beim Betrieb der Hydraulikeinheit möglichst gering zu halten. Dies trifft generell auch für herkömmliche Hydraulikflüssigkeiten zu. In Kombination mit den vorteilhaften Eigenschaften eines Flüssigmetalls tragen die genannten niedrigen Flüssigkeitsmengen jedoch noch umso mehr dazu bei, die Verluste und thermischen Einflüsse auf ein Minimum zu reduzieren.

Die Begrenzungswände des Hydraulikvolumens, insbesondere der Antriebs- und Abtriebskammern und hydraulischen Leitung(en) der Hydraulikeinheit, sind besonders vorteilhaft aus oder mit einem Material gebildet und/oder mit einem Material beschichtet, welches auch bei dauerhaftem Kontakt mit dem jeweiligen Flüssigmetall chemisch beständig ist. Viele Metalle sind korrosionsanfällig bei längerem Kontakt mit flüssigem Gallium oder galliumhaltigen Legierungen. Um die Begrenzungswände vor einer derartigen Korrosion zu schützen, können diese aus einem resistenten Material gebildet sein und/oder mit einer resistenten Schutzschicht versehen sein. Geeignete resistente Materialien sind Refraktärmetalle wie Tantal, Wolfram oder Ruthenium. Aber auch hinreichend reines Eisen oder Stahl (insbesondere das Material, das von dem Unternehmen Carpenter Steel unter dem Namen Consumet vertrieben wird), Nickel, Titannitrid (TiN) oder diamantartige Beschichtungen können hochgradig beständig gegenüber galliumhaltigen Flüssigmetallen sein.

Allgemein bevorzugt ist die Hydraulikeinheit dazu ausgebildet, eine von dem Festkörperaktor ausgehende Bewegung mit einem Übersetzungsverhältnis von ungleich 1 auf ein zu bewegendes Element, insbesondere eine zur Klemmung ausgebildete Klemmbacke, oder ein mit einem Vorsprung und/oder einer Ausnehmung versehenes Formschlusselement, welches zur Festlegung des Arretierkörpers mittels Formschluss ausgebildet ist, zu übertragen. Dabei muss das genannte "zu bewegendes Element" nicht notwendig Teil der Hydraulikeinheit sein. Das Übersetzungsverhältnis kann insbesondere kleiner als 1 gewählt sein, sodass der mechanische Hub auf der Austrittsseite der Hydraulikeinheit (also insbesondere der mit dem zu bewegenden Element verbundenen Seite oder der das Element aufweisenden Seite) größer ist als der Hub auf der Eintrittsseite der Hydraulikeinheit (also der mit dem Festkörperaktor verbundenen Seite). Auf diese Weise kann für die Aktoreinrichtung der Schalteinrichtung gemäß der Erfindung ein größerer Hub erzielt werden als für den einzelnen Festkörperaktor. Auf diese Weise kann der Nachteil des geringen Maximalhubs, der bei vielen solchen Festkörperaktoren vorliegt, zumindest teilweise ausgeglichen werden. Grundsätzlich kann in einer Weiterbildung der Erfindung das Übersetzungsverhältnis auch 1 sein. In einer bevorzugten Weiterbildung der erfindungsgemäßen Schalteinrichtung weist die Hydraulikeinheit wenigstens eine Antriebskammer und eine Abtriebskammer und vorzugsweise eine Antriebskammer und Abtriebskammer verbindende hydraulische Leitung auf. Alternativ können Antriebskammer und Abtriebskammer direkt, d.h. ohne vermittelnde hydraulische Leitung, miteinander verbunden sein und aneinander angeordnet sein. Die Innenräume dieser Kammern und ggf. dieser Leitung bilden dann zumindest einen Teil des genannten Hydraulikvolumens aus. Dabei soll jedoch nicht ausgeschlossen sein, dass das Hydraulikvolumen zusätzlich noch weitere hier nicht genannte Teile, insbesondere noch weitere Kammer(n) und/oder Leitung(en) umfasst. Zusätzlich kann das Hydraulikvolumen insbesondere mit einem oder mehreren Ventilen zwischen einzelnen Bestandteilen des Volumens gebildet sein.

Schalteinrichtungen mit derart ausgestalteten Hydraulikeinheiten eignen sich besonders gut, um durch die jeweilige Ausgestaltung der Antriebskammer und der Abtriebskammer ein vorbestimmtes Übersetzungsverhältnis für die Hydraulikeinheit einzustellen. Somit kann beispielsweise auch bei geringem Hub des Festkörperaktors ein vergleichsweise großer Hub im Bereich der Abtriebskammer der Hydraulikeinheit erreicht werden. Mit anderen Worten lässt sich durch das Zusammenspiel zwischen Festkörperaktor und Hydraulikeinheit ein zur Arretierung günstiges Übersetzungsverhältnis für die Bewegung der Aktoreinrichtung der Schalteinrichtung erreichen.

Die Antriebskammer kann insbesondere ein zugeordnetes Antriebselement aufweisen und/oder die Abtriebskammer kann ein zugeordnetes Antriebselement aufweisen. Bei diesen Antriebs- und Abtriebselementen kann es sich beispielsweise um Kolbenelemente oder ähnlich wirkende Elemente handeln, die zweckmäßig mit den Festkörperaktoren bewegungsgekoppelt sind. Die Antriebs- und Abtriebskammern können beispielsweise als Zylinder oder als Faltenbalge ausgestaltet sein.

Ein gewünschtes Übersetzungsverhältnis ist bei einer derartigen Hydraulikeinheit insbesondere durch unterschiedliche Form und/oder Größe der jeweiligen Antriebs- und Abtriebskammern und/oder durch unterschiedliche Wahl der Antriebs- und Abtriebselemente einstellbar.

In jedem Fall ist es allgemein bevorzugt, wenn die Hydraulikeinheit wenigstens ein die Antriebskammer teilweise begrenzendes Antriebselement aufweist, welches mittels des Festkörperaktors bewegbar ist. Dabei ist durch Bewegen des Antriebselements eine Strömung der Hydraulikflüssigkeit zwischen Antriebskammer und Abtriebskammer bewirkbar. Die Hydraulikeinheit kann zusätzlich wenigstens ein die Abtriebskammer teilweise begrenzendes Antriebselement aufweisen, welches wiederum durch die strömende Hydraulikflüssigkeit bewegbar ist und auf einer Ausgangsseite der Hydraulikeinheit ein, insbesondere äußeres, zu bewegendes Element bewegen kann. Insbesondere ist mittels des Festkörperaktors, vorzugsweise mittels des Antriebselements wie zuvor beschrieben, Hydraulikflüssigkeit aus der Abtriebskammer in die Antriebskammer beweglich, und/oder eine Druckminderung der Abtriebskammer bewirkbar. Auf diese Weise kann mittels einer Ansteuerung des Festkörperaktors eine Druckminderung der Abtriebskammer bewirkt werden. Insbesondere ist mittels einer Druckbeaufschlagung der Abtriebskammer der Arretierkörper arretierbar und mittels einer Druckminderung der Abtriebskammer der Arretierkörper freigebbar. Folglich kann in dieser Weiterbildung der Erfindung der Arretierkörper freigegeben werden, indem der Festkörperaktor ausgelenkt wird.

Allgemein ist es aber auch möglich und vorteilhaft, wenn für eine Bewegung ein Übersetzungsverhältnis größer als 1 erreicht wird. Dies kann insbesondere dazu vorteilhaft sein, um auf der Abtriebsseite (also der Ausgangsseite der Aktoreinrichtung) eine besonders hohe Kraft zu erreichen. Dies ist für die vorliegende Anwendung mit einer Arretierung relevant, bei der der Festkörperaktor zweckmäßig gegen ein festes Ende oder ein Ende mit einer sehr hohen Steifigkeit betrieben wird.

Die Hydraulikeinheit der erfindungsgemäßen Schalteinrichtung kann optional zusätzlich eine Vorratskammer für die Hydraulikflüssigkeit aufweisen. Vorzugsweise ist die Vorratskammer druckbeaufschlagt, insbesondere mittels eines in der Vorratskammer angeordneten Gasdruckspeichers und/oder mittels einer eine flexible Wandung der Vorratskammer kraftbeaufschlagenden Feder, d.h. eines federnden Elements.

Vorzugsweise ist bei der erfindungsgemäßen Schalteinrichtung die Vorratskammer druckbeaufschlagt, wobei die druckbeaufschlagte Vorratskammer zur Druckbeaufschlagung der Abtriebskammer, insbesondere mittels einer Druckbeaufschlagung der Antriebskammer, ausgebildet und hydraulisch angebunden ist. Auf diese kann die druckbeaufschlagte Vorratskammer die Abtriebskammer mit einem Druck beaufschlagen, in welcher mittels einer Ansteuerung des Festkörperaktors wie oben beschrieben eine Druckminderung bewirkbar ist. Folglich lässt sich mittels dieser Weiterbildung der Erfindung die Abtriebskammer derart vorspannen, dass der Arretierkörper dauerhaft mittels der druckbeaufschlagten Abtriebskammer arretiert, etwa geklemmt oder verriegelt, wird, wobei im Bedarfsfall der Arretierkörper infolge der Druckminderung der Abtriebskammer freigegeben werden kann. Idealerweise ist die Antriebskammer mittels eines Hydraulikzylinders realisiert, in welchem ein im Hydraulikzylinder geführter Hydraulikkolben eine Antriebskammer begrenzt. Vorzugsweise begrenzt der Hydraulikkolben die Antriebskammer an einer dem Festkörperaktor zugewandten Seite. Auf diese Weise kann eine Auslenkung des Festkörperaktors ein Hydraulikvolumen der Antriebskammer vorteilhaft vergrößern, sodass die Abtriebskammer infolge einer Strömung von Hydraulikflüssigkeit von der Abtriebskammer in die Antriebskammer druckgemindert wird. In dieser Weiterbildung ist folglich eine Druckminderung in der Abtriebskammer realisierbar, sodass ein Arretierkörper mittels einer Auslenkung des Festkörperaktors freigebbar ist. Auf diese Weise lässt sich eine sogenannte "*Normally-Closed"-*Schalteinrichtung realisieren, bei welcher im Normalfall der Arretierkörper arretiert ist und der Arretierkörper im Bedarfsfall mittels einer Ansteuerung des Festkörperaktors freigebbar ist. Geeigneterweise ist die Antriebskammer mit einer Drossel mit der Vorratskammer verbunden, sodass eine Änderung des Volumens der Antriebskammer in einer Änderung des Volumens der Abtriebskammer resultiert und Hydraulikflüssigkeit nicht im nennenswerten Umfang aus der Vorratskammer in die Antriebskammer strömt oder in die Vorratskammer zurück strömt. Vielmehr dient die Anbindung der Vorratskammer an die Antriebskammer mittels der Drossel vordringlich einer vorspannenden Druckbeaufschlagung der Antriebskammer und folglich auch der Abtriebskammer.

Gemäß einer besonders bevorzugten Weiterbildung der Erfindung ist der genannte Festkörperaktor ein Piezoaktor. Piezoaktoren haben sich in der Vergangenheit als besonders vielversprechende Ausgestaltungen des Festkörperaktors erwiesen. Mit ihnen kann eine besonders präzise Bewegung erreicht werden. Ihr Hauptnachteil, nämlich ihr geringer mechanischer Hub, kann wie beschrieben durch die nachfolgende Hydraulikeinheit ausgeglichen werden.

Besonders bevorzugt ist der Piezoaktor der Schalteinrichtung als Piezostapelaktor ausgebildet. Ein Piezostapelaktor ist eine aus dem Stand der Technik grundsätzlich bekannte Serienschaltung aus mehreren einzelnen Piezoelementen, welche als Schichtstapel angeordnet sind. Ein solcher Stapelaktor ist besonders vorteilhaft, um auch schon mit den Piezoaktor eine höhere Bewegungsamplitude zu erreichen als dies mit einem einzelnen Piezoelement möglich wäre.

Die Erfindung ist jedoch nicht notwendig auf einen Piezoaktor als Festkörperaktor beschränkt. So gelten viele der bekannten Vorteile und Nachteile von Piezoaktoren auch für andere Arten von Festkörperaktoren. Auch für sie kann ein vergleichsweise geringer Hub durch die nachfolgende Hydraulikeinheit vergrößert werden. Gemäß einer bevorzugten Weiterbildung der Erfindung ist der genannte Festkörperaktor beispielsweise ein magnetostriktiver Aktor oder ein elektrostriktiver Aktor. Alternativ kann es sich bei dem Festkörperaktor auch um einen Formgedächtnis-Aktor handeln.

In einer bevorzugten Weiterbildung der Erfindung weist die Schalteinrichtung eine Steuereinrichtung auf, welche eingerichtet ist, den Festkörperaktor abhängig von einer Bewegungsgröße des Arretierkörpers zu steuern. Die Bewegungsgröße ist zweckmäßig mit einem Ort und/oder einer Geschwindigkeit und/oder einer Beschleunigung des Arretierkörpers gebildet.

Mittels der erfindungsgemäß bei der Schalteinrichtung vorgesehenen Hydraulikeinrichtung sind somit nicht allein, gewissermaßen digital, Klemmkräfte für einen den Arretierkörper mit maximaler arretierender Kraft arretierenden Zustand und einen nicht arretierenden Zustand einstellbar, sondern es sind zudem sämtliche Zwischenzustände, im Falle oder Arretierung in Form von Klemmung sämtliche zwischen mit maximaler Klemmkraft klemmendem und nicht klemmendem Zustand befindlichen Zustände, einstellbar.

So lässt sich im Falle der Arretierung in Form von Klemmung insbesondere eine einen beweglichen Klemmkörper bremsende Klemmkraft einstellen. Besonders zweckmäßig weist in einer Weiterbildung die erfindungsgemäße Schalteinrichtung eine solche Steuereinrichtung auf, welche den Festkörperaktor derart stellt, dass der Klemmkörper, nachdem er infolge einer Aufhebung der Klemmung beschleunigt worden ist, abgebremst wird, insbesondere derart, dass ein Abprallen des ersten elektrischen Schaltkontakts vom zweiten, festgelegten elektrischen Schaltkontakt vermieden werden kann.

Insbesondere ist die Schalteinrichtung öffnend, d.h. den Arretierkörper freigebend, ausgeführt. In dieser Weiterbildung der Erfindung kann dann kann mit erneuter Arretierung, insbesondere erneutem Klemmen, ein Abprallen an einem typischerweise vorhandenen Endanschlag und/oder einem zweiten, festgelegten elektrischen Schaltkontakt, verhindert werden.

Bevorzugt ist die Steuereinrichtung ausgebildet, eine Steuerung der Füllung der Abtriebskammer und folglich eine Einstellung der Bremskraft auf den Klemmkörper mittels einer Rückkopplung zu steuern, indem eine Bewegungsgröße wie insbesondere ein Geschwindigkeitswert und/oder ein Beschleunigungswert und/oder ein Ortswert des Klemmkörpers oder eine davon abgeleitete Größe zur Rückkopplung herangezogen wird. Insbesondere ist die Steuereinrichtung zur Regelung der Klemmkraft ausgebildet, indem die Füllung der Abtriebskammer die Steuergröße und die Geschwindigkeit und/oder die Beschleunigung und/oder der Ort des Klemmkörpers die Führungs- oder Regelungsgröße bildet. Vorzugsweise wird die Regelung dann unternommen, nachdem die Klemmeinrichtung den Klemmkörper freigegeben hat und das Federelement den Klemmkörper beschleunigt hat. Insbesondere ist die Regelungseinrichtung ausgebildet, den Klemmkörper kontrolliert abzubremsen oder zu entprellen und/oder um insbesondere die Geschwindigkeit des Klemmkörpers in Abhängigkeit der Position des Klemmkörpers, und damit vorzugsweise eines Schalthubs, zu variieren.

In einer vorteilhaften Weiterbildung der Erfindung ist die Schalteinrichtung mehrfach ausgeführt und jeweils zur Schaltung je einer Phase einer mehrphasigen elektrischen Verbindung ausgebildet. Insbesondere ist jede der Schalteinrichtungen zur öffnenden Schaltung der jeweiligen Phase ausgebildet, vorzugsweise bei einem Nulldurchgang der Phasenspannung oder eines Phasenstroms der jeweiligen Phase. Folglich entsteht beim Öffnen kein oder nur ein sehr kurzer Lichtbogen und erster und ggf. zweiter elektrischer Schaltkontakt werden jeweils nur gering belastet. Folglich eignet sich die erfindungsgemäße Schalteinrichtung in dieser Weiterbildung für Hoch-, Mittel- und Niederspannung.

In einer besonders vorteilhaften Weiterbildung der Erfindung bildet der Klemmkörper einen Rotationskörper wie er in Druckschrift DE 10 2016 208 274 A1 beschrieben ist. Die Aktoreinrichtung bildet dabei vorzugsweise die in dieser Druckschrift beschriebene Arretierung. Auf diese Weise lassen sich die Vorteile des in dieser Druckschrift beschriebenen Kopplungsgliedes mit den Vorteilen der in der vorliegenden Anmeldung beschriebenen Schalteinrichtung sehr einfach kombinieren. Der Offenbarungsgehalt der Druckschrift DE 10 2016 208 274 A1 sei daher in die vorliegende Anmeldung mit einbezogen.

Das erfindungsgemäße Verfahren dient zum Schalten eines elektrischen Schalters und zieht dazu eine erfindungsgsmäße Schalteinrichtung heran, wobei die Schalteinrichtung eine Aktoreinrichtung mit einem Festkörperaktor und einer zu dem Festkörperaktor mechanisch in Serie geschaltete Hydraulikeinheit aufweist. Dabei weist die Hydraulikeinheit ein Hydraulikvolumen auf, welches mit einer Hydraulikflüssigkeit befüllbar oder befüllt ist. Dabei ist der Schalter mit mindestens einem elektrischen Schaltkontakt der Schalteinrichtung gebildet.

Nachfolgend wird die Erfindung anhand eines in der Zeichnung dargestellten Ausführungsbeispiels näher erläutert. Es zeigen:
- Fig. 1: zeigt eine erfindungsgemäße Schalteinrichtung mit einer Aktoreinrichtung mit einer Hydraulikeinheit schematisch in einer Prinzipskizze,
- Fig. 2: ein zweites Ausführungsbeispiel einer erfindungsgemäßen Schalteinrichtung mit einer Hydraulikeinheit schematisch in einer Prinzipskizze, sowie
- Fig. 3: ein drittens Ausführungsbeispiel einer erfindungsgemäßen Schalteinrichtung mit einer Hydraulikeinheit schematisch in einer Prinzipskizze.

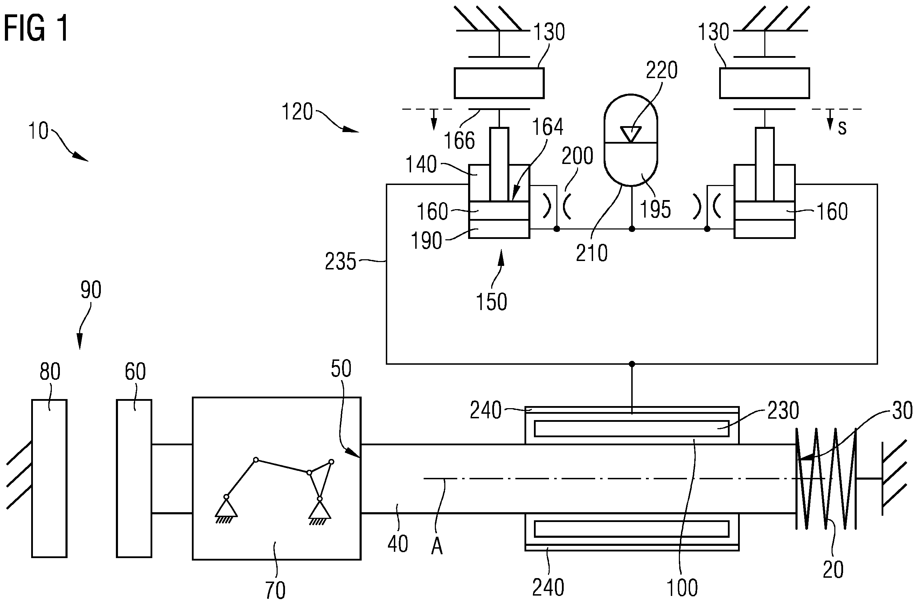

Wie in Fig. 1 anhand eines ersten Ausführungsbeispiels dargestellt umfasst die erfindungsgemäße Schalteinrichtung 10 ein Federelement 20, vorliegend beispielsweise eine Druckfeder in Gestalt einer Schraubenfeder, welches an einer Stirnseite 30 einer kreiszylindrischen Welle 40 angeordnet ist und die Welle 40 an dieser Stirnseite 30 in axialer Richtung A kraftbeaufschlagt. In weiteren, nicht eigens gezeigten Ausführungsbeispielen kann die Welle 40 anstelle eines kreisförmigen Querschnitts auch einen polygonförmigen Querschnitt aufweisen. Die Welle 40 ist an einer weiteren, dem Federelement 20 fernen, Stirnseite 50 mit einem ersten elektrischen Schaltkontakt 60 bewegungsgekoppelt. Die Welle 40 kann dazu direkt an den ersten Schaltkontakt 60 angebunden, beispielsweise verschweißt, sein oder es kann eine Übersetzungseinheit 70 vorhanden sein, welche einen Weg der Welle 40 in einen Weg des ersten Schaltkontakts 60 übersetzt, in gezeigten Ausführungsbeispiel mit einem Übersetzungsfaktor größer als eins übersetzt, d.h. eine Bewegung der Welle 40 wird in einen um diesen Übersetzungsfaktor größeren Weg des ersten Schaltkontakts 60 übersetzt. Im gezeigten Ausführungsbeispiel weist die Übersetzungseinheit 70 eine Kontaktdruckfeder auf. In weiteren, nicht eigens dargestellten Ausführungsbeispielen kann die Übersetzungseinheit 70 jedoch auch auf sonstige Weise gebildet sein oder entfallen und/oder ein Übersetzungsverhältnis kleiner als eins oder größer als eins aufweisen.

Der erste elektrische Schaltkontakt 60 bildet ein Gegenstück zu einem weiteren, zweiten, elektrischen Schaltkontakt 80, mit welchem der erste elektrische Schaltkontakt 60 einen elektrischen Schalter 90 der erfindungsgemäßen Schalteinrichtung 10 bildet. Im Gegensatz zum ersten, mit der Übersetzungseinheit 70 beweglichen, elektrischen Schaltkontakt 60 ist der zweite elektrische Schaltkontakt 80 festgelegt. Liegen erster elektrischer Schaltkontakt 60 und zweiter elektrischer Schaltkontakt 80 aneinander an, so ist der elektrische Schalter 90 geschlossen. Der elektrische Schalter 90 ist geöffnet, wenn erster 60 und zweiter elektrischer Schaltkontakt 80 voneinander beabstandet sind. Folglich ist im gezeigten Ausführungsbeispiel der elektrische Schalter 90 allein mittels Bewegung des ersten elektrischen Schaltkontakts 60 öffenbar und schließbar.

Erster elektrischer Schaltkontakt 60 und zweiter elektrischer Schaltkontakt 80 können grundsätzlich auf unterschiedliche Art und Weise ausgeführt sein. Im dargestellten Ausführungsbeispiel sind erster 60 und zweiter Schaltkontakt 80 als Plattenkontakte ausgeführt, wie man sie z.B. in den in der Mittelspannung üblichen Vakuumschaltröhren findet. Grundsätzlich können erster 60 und zweiter Schaltkontakt 80 jedoch auch als sonstige Kontakte, z.B. als PinTulpe-Kontakte, wie sie z.B. in der Hochspannnung üblich sind, ausgebildet sein.

In der in Fig. 1 dargestellten Situation ist der erste 60 elektrische Schaltkontakt von dem zweiten elektrischen Schaltkontakt 80 beabstandet, d.h. der elektrische Schalter 90 ist geöffnet.

Das Federelement 20 ist vorspannend in axialer Richtung A gestaucht und ist an ihrer Entspannung infolge einer Arretierung der Welle 40 in axialer Richtung A gehindert. Die Welle 40 ist in axialer Richtung A mittels einer Klemmbacke 100 festgelegt, welche in radialer Richtung auf die Welle 40 zu kraftbeaufschlagt ist und die Welle 40 reibschlüssig in ihrer axialen Position hält.

Die Klemmbacke 100 ist ausgebildet, die Kraftbeaufschlagung auf die Welle 40 zu unterbrechen zu können und die Welle 40 axial freigeben zu können. Infolge einer Freigabe der Welle 40 kann sich das Federelement 20 entspannen und die Welle 40 in axialer Richtung A kraftbeaufschlagen. Aufgrund der Kraftbeaufschlagung der Welle 40 mittels des Federelements 20 ist die Welle 40 in axialer Richtung A beweglich, sodass der erste elektrische Schaltkontakt 60 auf den zweiten elektrischen Schaltkontakt 80 zu beweglich ist und der Schalter 90 schließbar ist. Die Klemmbacke 100 ist im dargestellten Ausführungsbeispiel zur reibschlüssigen Ineingriffnahme der Welle 40 zwischen Federelement 20 und erstem Schaltkontakt 60 angeordnet. Aus Richtung des Federelement 20 gesehen, kann die Klemmbacke 100 wie dargestellt vor der optionalen Übersetzungseinheit 70 angeordnet sein. In weiteren, nicht eigens gezeigten Ausführungsbeispielen kann die Klemmbacke 100 auch hinter der Übersetzungseinheit 70 angeordnet sein. Je nach Übersetzung kann so eine geringere Klemmkraft erforderlich sein.

Die Klemmbacke 100 ist Teil einer Hydraulikeinheit 120, mittels welcher die Klemmbacke 100 wie nachfolgend beschrieben kontrolliert beweglich betreibbar ist:
Die Hydraulikeinheit 120 bildet mit der Klemmbacke 100 und der mittels der Klemmbacke 100 klemmbaren Welle 40 eine Klemmeinrichtung zur ultraschnellen Druckreduktion.

Die Hydraulikeinheit 120 weist wie in Fig. 1 dargestellt einen Festkörperaktor 130 auf, welcher im gezeigten Ausführungsbeispiel mit einem Piezoaktor gebildet ist.

Dieser Festkörperaktor 130 ist im gezeigten Ausführungsbeispiel mittels einer Antriebskammer 140 eines doppelt wirkenden Hydraulikzylinders 150 in Gestalt eines Kolbenzylinders gekoppelt. Gekoppelt meint in diesem Zusammenhang, dass der Festkörperaktor 130 derart mit einer Begrenzung der Antriebskammer 140 des Hydraulikzylinders 150 verbunden ist, dass die Antriebskammer 140 infolge einer Auslenkung des Festkörperaktors 130 ihr Volumen ändert. Im gezeigten Ausführungsbeispiel ist die Antriebskammer 140 des Kolbenzylinders in an sich bekannter Weise von einem im Kolbenzylinder in einer axialen Richtung des Kolbenzylinders verschieblichen Hydraulikkolben 160 volumenbegrenzt und der Festkörperaktor 130 mit dem Hydraulikkolben 160 bewegungsgekoppelt, etwa formschlüssig mit einer an einer Stirnseite 164 des Hydraulikkolbens 160 angeordneten Handhabe 166, verbunden. In weiteren, nicht eigens dargestellten Ausführungsbeispielen ist anstelle des Kolbenzylinders ein Hydraulikzylinder 150 in Gestalt eines metallischen Faltenbalges vorhanden, welcher eine bewegliche Stirnseite aufweist, die mit dem Festkörperaktor 130 bewegungsgekoppelt ist.

Grundsätzlich kann der Hydraulikzylinder 150 auch auf andere Weise realisiert sein. Erfindungsgemäß wesentlich ist insbesondere, dass mittels einer Bewegung des Festkörperaktors 130 ein hydraulisches Antriebsvolumen geändert wird.

Im gezeigten Ausführungsbeispiel trennt der Hydraulikkolben 160 zwei Volumina. An einer dem Festkörperaktor 130 nahen Stirnseite des Hydraulikkolbens 160 liegt das Antriebsvolumen der Antriebskammer 140 an, d.h. bei Auslenkung des Festkörperaktors 130 in Richtung auf den Hydraulikkolben 160 zu nimmt das Antriebsvolumen der Antriebskammer 140 in seiner Größe zu.

Ein weiteres Volumen 190 des Hydraulikzylinders 150 liegt an einer dem Festkörperaktor 130 fernen Seite des Hydraulikkolbens 160 an.

Antriebsvolumen der Antriebskammer 140 und weiteres Volumen 190 des Hydraulikzylinders 150 sind mit einer Hydraulikflüssigkeit 195 gefüllt. Grundsätzlich kann die Hydraulikflüssigkeit 195 mit Wasser oder mit einer sonstigen Flüssigkeit gebildet sein. Im dargestellten Ausführungsbeispiel ist die Hydraulikflüssigkeit 195 mit einem Flüssigmetall, beispielsweise Galinstan, gebildet. Flüssigmetall weist eine besonders niedrige Kompressibilität und einen besonders geringen thermischen Ausdehnungskoeffizienten auf.

Das weitere Volumen 190 ist über eine in der Praxis stets vorhandene Leckage mit dem Antriebsvolumen verbunden. Die Leckage ist in Fig. 1 mit einer zum Hydraulikkolben 160 parallel geschalteten Drossel 200 symbolisiert.

Das weitere Volumen 190 ist fluidleitend mit einem mit Hydraulikflüssigkeit 195 gefüllten Reservoir 210 verbunden. Das Reservoir 210 ist mittels eines Druckbeaufschlagungsmittels 220 vorgespannt, d.h. mit einem Druck, hier einem Überdruck, beaufschlagt. Infolge der Leckage ist nicht allein das weitere Volumen 190, sondern die gesamte Hydraulikeinheit 120, d.h. insbesondere auch das Antriebsvolumen der Antriebskammer 140, mit dem Überdruck beaufschlagt.

Das Druckbeaufschlagungsmittel 220 ist im dargestellten Ausführungsbeispiel ein im Reservoir 210 befindlicher Gasdruckspeicher. In weiteren, nicht eigens dargestellten Ausführungsbeispielen kann das Druckbeaufschlagungsmittel 220 auch mit einer Feder gebildet sein, welche eine flexible Wandung des Reservoirs derart kraftbeaufschlagt, dass das Reservoir 210 mit einem Druck beaufschlagt wird.

Die Antriebskammer 140 ist fluidleitend mittels Fluidleitungen 235 mit einer Abtriebskammer 230 verbunden, in welcher zur Realisierung einer Klemmung der Welle 40 ein Druckabfall realisierbar ist:
Wird der Festkörperaktor 130 sprunghaft, d.h. mittels eines Spannungspulses, angesteuert, so wird der Festkörperaktor 130 in Richtung s ausgelenkt und treibt die Handhabe 166 des Hydraulikkolbens 160 axial. Dadurch wird Hydraulikflüssigkeit 195 in das Reservoir 210 geschoben. Da das Druckbeaufschlagungsmittel 220 verglichen mit der Hydraulikflüssigkeit 195 eine geringere Federsteifigkeit aufweist, ist der Druckanstieg infolge der geringen Ausdehnung des Festkörperaktors 130 gering. Infolge der Auslenkung des Hydraulikkolbens 160 erfolgt jedoch eine Volumenänderung in der hydraulischen Abtriebskammer 230.

Der Druckabfall ist dabei proportional zum Quotienten aus relativer Volumenänderung und Kompressibilität der Hydraulikflüssigkeit:
Die relative Volumenänderung bedeutet dabei die Volumenänderung bezogen auf ein Anfangsvolumen vor der Volumenänderung.

Die absolute Volumenänderung ist im dargestellten Ausführungsbeispiel durch den Festkörperaktor 130 vorgegeben. Um einen möglichst hohen Druckabfall zu erzielen, ist für einen hohen Druckabfall das hydraulische Anfangsvolumen möglichst gering gehalten und eine Hydraulikflüssigkeit 195 mit besonders geringer Kompressibilität gewählt.

Der thermische Ausdehungskoeffizient eines Flüssigmetalls wie Galinstan beträgt 0,000126 1/K und damit nur ein Fünftel von Glycerin und nur die Hälfte von Wasser. Dadurch kann der temperaturbedingte Einfluss auf den Druck in der Abtriebskammer 230 verringert werden.

Je geringer Anfangsvolumen und Kompressibilität sind, desto weniger Energie muss von den Festkörperaktoren 130 bereitgestellt werden, um einen bestimmten Druckabfall zu realisieren.

Zusätzlich kann für einen möglichst hohen Druckabfall wie im gezeigten Ausführungsbeispiel der Festkörperaktor 130 mit der hydraulischen Antriebskammer wie in Fig. 1 dargestellt zweifach oder mehrfach vorgesehen sein.

Die Abtriebskammer 230 der Hydraulikeinheit 120 weist eine Gestalt eines kreiszylindrischen Rohres auf, welches die Welle 40 entlang eines axialen Abschnitts vollumfänglich umgibt. Die Abtriebskammer 230 ist in ein umfängliches Rohr 240 eingebracht und folglich außenumfänglich festgelegt. Infolge einströmender Hydraulikflüssigkeit 195 ist ein Innendurchmesser der Abtriebskammer 230 der Hydraulikeinheit 120 verringerbar, sodass die Abtriebskammer 230 sich abhängig von einströmender Hydraulikflüssigkeit 195 reibschlüssig um die Welle 40 herum an dieser anlegt.

Der an der Welle 40 anlegbare Teil der Oberfläche der Abtriebskammer 230 bildet die oben erwähnte Klemmbacke 100 der erfindungsgemäßen Schalteinrichtung 10. Mittels dieser Klemmbacke 100 ist die Welle 40 kraftschlüssig festlegbar: Infolge des ursprünglichen Anfangsdrucks im hydraulischen System ist die Klemmbacke 100 in Richtung auf die Welle 40 zu kraftbeaufschlagt, sodass die Welle 40 im Ausgangszustand geklemmt ist.

Im Falle eines kritischen Zustandes eines mit der erfindungsgemäßen Schalteinrichtung 10 versehenen Systems soll der Schalter 90 der Schalteinrichtung 10 rasch geschlossen werden. Dazu wird die Welle 40 von der Klemmbacke 100 freigegeben, sodass sich das Federelement 20 entspannen kann und die Welle 40 in axialer Richtung A beschleunigt. Das Federelement 20 ist wie zuvor beschrieben als mechanische Druckfeder ausgebildet sein. Alternativ ist anstelle einer mechanischen Druckfeder eine Druckgasfeder oder ein sonstiges Federelement 20 vorhanden.

Im Falle eines kritischen Zustandes lässt sich die bis dahin in er Klemmbacke 100 geklemmte Welle 40 freigegeben, indem der oder - im Falle mehrerer parallel geschalteter Festkörperaktoren 130 die - Festkörperaktoren 130 angesteuert werden, um eine Druckabsenkung in der Abtriebskammer 230 zu bewirken. Dadurch ist die Klemmung zwischen der Klemmbacke 100 und Welle 40 lösbar und die Welle aufgrund des Federelements 20 beschleunigbar. Auf diese Weise ist die Welle 40 mit besonders geringem zeitlichen Verzug bewegbar.

Es versteht sich, dass anstelle des Federelements 20 in weiteren, nicht eigens dargestellten Ausführungsbeispielen ein elektromechanischer Antrieb vorgesehen sein kann, wobei die Antriebsenergie beispielsweise in Kondensatoren vorgehalten wird.

Mittels der erfindungsgemäß bei der Schalteinrichtung 10 vorgesehenen Hydraulikeinrichtung 120 sind zudem nicht allein, gewissermaßen digital, Klemmkräfte für einen die Welle 40 mit maximaler Klemmkraft klemmenden Zustand und einen die Welle 40 nicht klemmenden Zustand einstellbar, sondern es sind zudem sämtliche zwischen mit maximaler Klemmkraft klemmendem und nicht klemmendem Zustand befindlichen Zustände einstellbar: So lässt sich insbesondere eine die Welle 40 in axialer Richtung A bremsende Klemmkraft einstellen. Nicht eigens in der Zeichnung dargestellt ist eine Steuereinrichtung vorhanden, welche die Festkörperaktoren 130 derart stellt, dass die Welle 40, nachdem sie von der Klemmbacke 100 freigegeben worden ist, abgebremst wird und zwar derart, dass ein Abprallen des ersten elektrischen Schaltkontakts 60 vom zweiten, festgelegten elektrischen Schaltkontakt 80 vermieden werden kann. Die Steuereinrichtung ist ausgebildet, eine Steuerung der Füllung der Abtriebskammer 230 und folglich eine Einstellung der Bremskraft auf den die Welle 40 durch die Klemmbacke 100 mittels einer Rückkopplung zu steuern, indem ein Beschleunigungswert sowie ein Geschwindigkeits- und ein Ortswert der Welle 40 zur Rückkopplung herangezogen wird. Dabei wird die Klemmkraft mittels Füllung der Abtriebskammer 230 derart eingestellt, dass die Welle 40 bei ihrem Anschlag mit dem ersten elektrischen Schaltkontakt 60 an dem zweiten elektrischen Schaltkontakt 80 abrupt abgebremst wird. Vorzugsweise wird diese Regelung erst dann unternommen, nachdem die Klemmbacke 100 die Welle 40 freigegeben hat und das Federelement 20 die Welle 40 beschleunigt hat.

Im gezeigten Ausführungsbeispiel ist die Schalteinrichtung 10 zur schließenden Schaltung des Schalters 90 ausgebildet. Grundsätzlich lässt sich die Schalteinrichtung 10 auch zur Öffnung des Schalters 90 ausbilden, beispielsweise durch entsprechende Anordnung des Federelements 20 an der Welle 40. In diesem weiteren Ausführungsbeispiel wird der Schalter 90 im Bedarfsfall, etwa in einem Fehlerfall oder in einem sonstigen Notfall, geöffnet. In einer spezifischen Ausgestaltung kann die Schalteinrichtung 10 dreifach ausgebildet sein und zur Schaltung je einer Phase einer dreiphasigen elektrischen wechselspannungsführenden Leitung angeordnet sein. Im Bedarfsfall wird jede Phase unterbrochen, d.h. öffnend geschaltet, allerdings nicht genau gleichzeitig. Vielmehr wird jede Phase zu einem Nulldurchgang der jeweils anliegenden Wechselspannung geöffnet. Hierzu umfasst die dreifach ausgebildete Schalteinrichtung 10 eine Koordinationseinrichtung (nicht eigens dargestellt), die die Spannung jeder Phase zeitaufgelöst am Ort je eines Schalters 90 zur Koordinierung der Öffnung dieses jeweiligen Schalters 90 heranzieht.

In einer besonders spezifischen Ausgestaltung ist die Welle 40 im Detail so ausgebildet wie der Rotationskörper 12 der Druckschrift DE 10 2016 208 274 A1. Die Klemmbacke 100 kann dabei die Arretierung 20 wie in dieser Druckschrift beschrieben bilden, wobei Festkörperaktor 130 und Hydraulikeinheit 120 (ausgenommen die Klemmbacke 100 selbst) den Aktor 22 dieser Druckschrift bilden. Hierzu sei das Ausführungsbeispiel der Druckschrift DE 10 2016 208 274 A1 in den Offenbarungsgehalt der vorliegenden Anmeldung mit einbezogen.

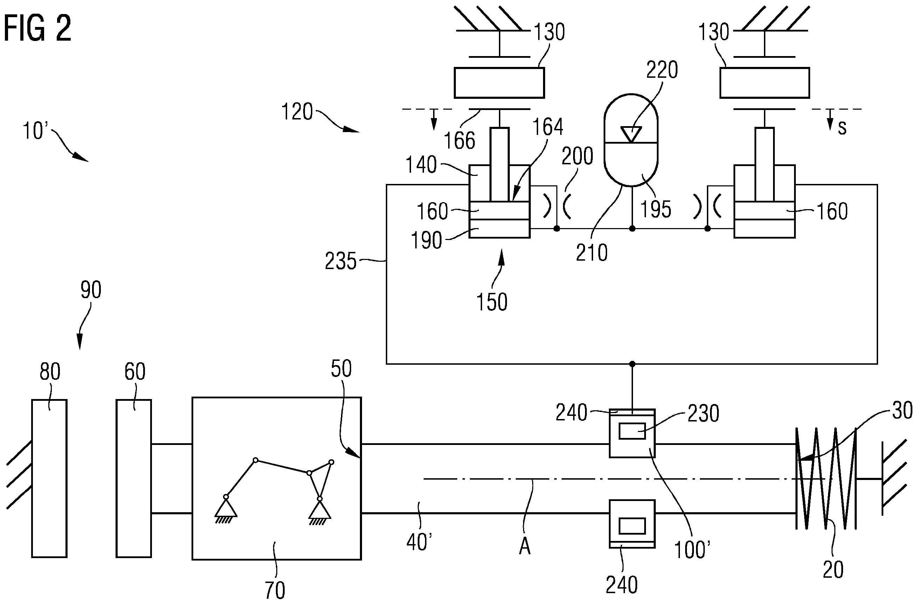

Das in Fig. 2 dargestellte weitere Ausführungsbeispiel einer erfindungsgemäßen Schalteinrichtung 10' entspricht weitgehend dem in Fig. 1 dargestellten Ausführungsbeispiel einer erfindungsgemäßen Schalteinrichtung 10.

Die Schalteinrichtung 10' weist jedoch abweichend von dem vorgehend beschriebenen Ausführungsbeispiel anstelle einer mit einer Klemmbacke 100 klemmbaren Welle 40 eine mit einem Riegel 100' klemmbare Welle 40' auf. Dazu weist die Welle 40' eine vollumfänglich verlaufende Einschnürung 42' auf, welche eine Ausnehmung bildet, in welche der Riegel 100' eingreifen kann. Der Riegel 100' ist als sich radial einwärts erstreckender, vollumfänglich an einem Innenumfang der Abtriebskammer 230 angeordneter Vorsprung ausgebildet, welcher demgemäß radial in die Ausnehmung 42' einkragt. Die Abtriebskammer 230 weist dazu in axialer Richtung kürzere Abmessungen auf verglichen mit dem vorangegangenen Ausführungsbeispiel.

Auf diese Weise kann der Riegel 100' mittels einer Befüllung der Abtriebskammer 230 in die Ausnehmung 42' eingebracht werden und mittels einer Druckreduzierung und somit einer Entleerung der Abtriebskammer 230 aus der Ausnehmung 42' ausgebracht werden. Entsprechend ist in diesem in Fig. 2 gezeigten Ausführungsbeispiel die Welle 40' formschlüssig mittels des Riegels 100' festlegbar.

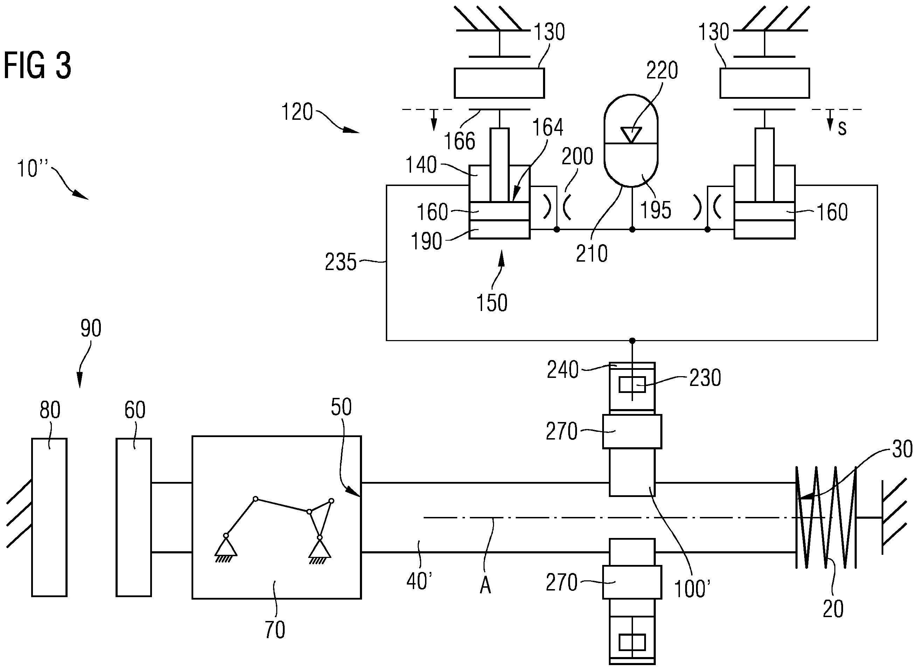

Das in Fig. 3 dargestellte Ausführungsbeispiel einer erfindungsgemäßen Schalteinrichtung 10" entspricht bis auf den nachfolgend beschriebenen Umstand dem zuvor beschriebenen Ausführungsbeispiel der erfindungsgemäßen Schalteinrichtung 10'. Dabei weist der Riegel 100' zusätzlich eine Übersetzung 270 auf, welche eine Bewegung eines Innenumfangs der Abtriebskammer 230 mit einem Übersetzungsfaktor versieht, sodass der Riegel 100' nicht direkt bewegt wird, sondern entsprechend dem Übersetzungsfaktor übersetzt bewegt wird.

Im Falle der anhand der Figuren 1 bis 3 dargestellten Ausführungsbeispiele handelt es sich um sogenannte "Normally-Closed"-Schalteinrichtungen, d.h. die Wellen 40, 40' sind im Betriebszustand dauerhaft festgelegt, also arretiert. Die Wellen 40, 40' werden nur im Bedarfsfall, etwa eines kritischen Zustands, freigegeben und mittels der Federelemente 20 beschleunigt.

Grundsätzlich können Schalteinrichtungen in weiteren, nicht eigens dargestellten Ausführungsbeispielen auch als "Normally-Open"-Schalteinrichtungen ausgebildet sein, bei welchen die Wellen 40, 40' nur im Bedarfsfall, in der Regel einem Ausnahmefall, festgelegt sind.

## Patentansprüche

1. Schalteinrichtung, umfassend mindestens einen elektrischen Schaltkontakt (60) sowie eine zur Klemmung ausgebildete Aktoreinrichtung (AE) mit einem Festkörperaktor (130) und einer zu dem Festkörperaktor (130) mechanisch in Serie geschalteten Hydraulikeinheit (120), wobei die Hydraulikeinheit (120) ein Hydraulikvolumen aufweist, welches mit einer Hydraulikflüssigkeit (195) befüllt ist, wobei die Schalteinrichtung zudem einen Arretierkörper (40) aufweist, welcher mit der Aktoreinrichtung arretierbar ist und welcher mit dem mindestens einen elektrischen Schaltkontakt (60) bewegungsgekoppelt ist, **dadurch gekennzeichnet, dass** der Arretierkörper ein Klemmkörper (40) ist, welcher mittels der Hydraulikeinheit (120) klemmbar ist und/oder ein Formschlusskörper (40') ist, welcher mittels der Hydraulikeinheit (120) formschlüssig festlegbar ist.

2. Schalteinrichtung nach dem vorhergehenden Anspruch, welche ein Federelement (20) und/oder Antriebselement aufweist, welches zur Kraftbeaufschlagung des Arretierkörpers (40) und/oder zum Antrieb des Arretierkörpers (40), insbesondere an dem Arretierkörper (40), angeordnet und ausgebildet ist.

3. Schalteinrichtung nach einem der vorhergehenden Ansprüche, bei welcher das Federelement (20) oder Antriebselement einen Druckspeicher und/oder einen Magneten aufweist.

4. Schalteinrichtung nach einem der vorhergehenden Ansprüche, bei welcher die Aktoreinrichtung mindestens eine Klemmfläche (100) aufweist, welche zur reibschlüssigen Ineingriffnahme des als Klemmkörper ausgebildeten Arretierkörpers (40) ausgebildet ist und/oder einen Vorsprung (100') und/oder eine Ausnehmung aufweist, welcher zur formschlüssigen Ineingriffnahme des als Formschlusskörper ausgebildeten Arretierkörpers (40') oder mit dem als Formschlusskörper ausgebildeten Arretierkörper (40') ausgebildet ist.

5. Schalteinrichtung nach einem der vorhergehenden Ansprüche, bei welcher die Aktoreinrichtung ausgebildet ist, den Klemmkörper (40) umfänglich, vorzugsweise vollumfänglich, zu klemmen.

6. Schalteinrichtung nach einem der vorhergehenden Ansprüche, bei welcher die Hydraulikflüssigkeit (195) ein Flüssigmetall, insbesondere Gallium, Indium, Zinn und/oder Quecksilber, und/oder eine eutektische Legierung und/oder eine Hydraulikflüssigkeit (195) ist oder aufweist, welche bei Normaldruck bei einer Temperatur von 20 °C, vorzugsweise 0 °C und idealerweise -20 °C, und/oder bei einer Betriebstemperatur und bei einem Betriebsdruck der Schalteinrichtung flüssig ist.

7. Schalteinrichtung nach einem der vorhergehenden Ansprüche, bei welcher die Hydraulikeinheit (120) dazu ausgebildet ist, eine von dem Festkörperaktor (130) ausgehende Bewegung mit einem Übersetzungsverhältnis von ungleich eins auf ein zu bewegendes Element (100), insbesondere eine zur Klemmung des Klemmkörpers (40) ausgebildete Klemmbacke und/oder ein zur formschlüssigen Festlegung des Formschlusskörpers (40') ausgebildetes Formschlusselement (100'), zu übertragen.

8. Schalteinrichtung nach einem der vorhergehenden Ansprüche, bei welcher die Hydraulikeinheit (120) wenigstens eine Antriebskammer (140), eine Abtriebskammer (230) und vorzugsweise eine diese Antriebskammer (140) und Abtriebskammer (230) verbindende hydraulische Leitung (235) aufweist.

9. Schalteinrichtung nach einem der vorhergehenden Ansprüche, bei welcher die Hydraulikeinheit (120) wenigstens ein die Antriebskammer (140) teilweise begrenzendes Antriebselement (160) aufweist, welches mittels des Festkörperaktors (130) bewegbar ist, wobei durch Bewegen des Antriebselements (160) eine Strömung der Hydraulikflüssigkeit (195) zwischen Antriebskammer (140) und Abtriebskammer (230), insbesondere aus der Abtriebskammer (140) in die Antriebskammer (230), und/oder eine Druckminderung der Abtriebskammer (140) bewirkbar ist.

10. Schalteinrichtung nach einem der vorhergehenden Ansprüche, bei welcher die Hydraulikeinheit (120) zusätzlich eine, vorzugsweise druckbeaufschlagte, Vorratskammer (210) für die Hydraulikflüssigkeit (195) aufweist.

11. Schalteinrichtung nach einem der vorhergehenden Ansprüche, zumindest nach den Ansprüchen 8 und 10, bei welcher die Vorratskammer (210) druckbeaufschlagt ist und wobei die druckbeaufschlagte Vorratskammer (210) zur Druckbeaufschlagung der Abtriebskammer (230), insbesondere mittels einer Druckbeaufschlagung der Antriebskammer (140), ausgebildet und hydraulisch angebunden ist.

12. Schalteinrichtung nach einem der vorhergehenden Ansprüche, bei welcher der Festkörperaktor (130) als oder mit einem Piezoaktor und/oder Piezostapelaktor ausgebildet ist und/oder ein magnetostriktiver Aktor oder ein elektrostriktiver Aktor und/oder ein Formgedächtnis-Aktor ist oder einen solchen Aktor aufweist.

13. Schalteinrichtung nach einem der vorhergehenden Ansprüche, bei welchem die Aktoreinrichtung mindestens zwei Arretierkörper (40, 40') aufweist, welche mit je mindestens einem elektrischen Schaltkontakt bewegungsgekoppelt sind.

14. Schalteinrichtung nach einem der vorhergehenden Ansprüche, bei welcher eine Steuereinrichtung vorhanden ist, welche eingerichtet ist, den Festkörperaktor abhängig von einer Bewegungsgröße des Arretierkörpers (40, 40') und/oder einer Kraftbeaufschlagung des Arretierkörpers (40, 40') zu steuern.

15. Verfahren zum Schalten eines Schalters mit einer Schalteinrichtung nach einem der vorhergehenden Ansprüche, bei welchem der Schalter den mindestens einen Schaltkontakt (60) der Schalteinrichtung (10) aufweist.

16. Verfahren nach einem der vorhergehenden Ansprüche, bei welchem ein Schalter mit mindestens zwei oder mehr Phasen geschaltet wird und der Schalter je Phase mindestens einen Schaltkontakt der Schalteinrichtung (10) aufweist.

## Claims

1. Switching device, comprising at least one electrical switching contact (60) and an actuator device (AE) which is designed for clamping and has a solid-state actuator (130) and a hydraulic unit (120) which is mechanically connected to the solid-state actuator (130) in series, wherein the hydraulic unit (120) has a hydraulic volume that is filled with a hydraulic fluid (195), wherein the switching device additionally has a locking body (40) that can be locked with the actuator device and that is coupled in terms of movement to the at least one electrical switching contact (60), **characterized in that** the locking body is a clamping body (40) that can be clamped by means of the hydraulic unit (120) and/or is a positively locking body (40') that can be secured in a positively locking manner by means of the hydraulic unit (120) .

2. Switching device according to the preceding claim, which has a spring element (20) and/or drive element that are/is arranged and designed, in particular on the locking body (40), to apply force to the locking body (40) and/or to drive the locking body (40).

3. Switching device according to either of the preceding claims, in which the spring element (20) or drive element has a pressure accumulator and/or a magnet.

4. Switching device according to one of the preceding claims, in which the actuator device has at least one clamping face (100) that is designed for non-positively locking engagement of the locking body (40) which is designed as a clamping body, and/or has a projection (100') and/or a recess that is designed for positively locking engagement of the locking body (40') which is designed as a positively locking body or with the locking body (40') which is designed as a positively locking body.

5. Switching device according to one of the preceding claims, in which the actuator device is designed to clamp the clamping body (40) around the circumference, preferably around the entire circumference.

6. Switching device according to one of the preceding claims, in which the hydraulic fluid (195) is or contains a liquid metal, in particular gallium, indium, tin and/or mercury, and/or a eutectic alloy and/or a hydraulic fluid (195) that is liquid at normal pressure at a temperature of 20°C, preferably 0°C and ideally -20°C, and/or at an operating temperature and at an operating pressure of the switching device.

7. Switching device according to one of the preceding claims, in which the hydraulic unit (120) is designed to transmit a movement, starting from the solid-state actuator (130), with a transmission ratio not equal to one to an element (100) to be moved, in particular a clamping jaw which is designed for clamping the clamping body (40) and/or a positively locking element (100') which is designed for securing the positively locking body (40') in a positively locking manner.

8. Switching device according to one of the preceding claims, in which the hydraulic unit (120) has at least a drive chamber (140), an output chamber (230) and preferably a hydraulic line (235) which connects this drive chamber (140) and output chamber (230).

9. Switching device according to one of the preceding claims, in which the hydraulic unit (120) has at least one drive element (160) which partially delimits the drive chamber (140) and is movable by means of the solid-state actuator (130), wherein, by way of moving the drive element (160), a flow of the hydraulic fluid (195) between the drive chamber (140) and the output chamber (230), in particular out of the output chamber (140) into the drive chamber (230), and/or a reduction in pressure in the output chamber (140) can be implemented.

10. Switching device according to one of the preceding claims, in which the hydraulic unit (120) additionally has a, preferably pressurized, reservoir (210) for the hydraulic fluid (195).

11. Switching device according to one of the preceding claims, at least according to Claims 8 and 10, in which the reservoir (210) is pressurized and wherein the pressurized reservoir (210) is designed and hydraulically connected to pressurize the output chamber (230), in particular by means of pressurizing the drive chamber (140).

12. Switching device according to one of the preceding claims, in which the solid-state actuator (130) is designed as or with a piezo actuator and/or piezo stack actuator and/or is a magnetostrictive actuator or an electrostrictive actuator and/or a shape-memory actuator or has such an actuator.

13. Switching device according to one of the preceding claims, in which the actuator device has at least two locking bodies (40, 40') which are coupled in terms of movement to in each case at least one electrical switching contact.

14. Switching device according to one of the preceding claims, in which a control device is provided which is designed to control the solid-state actuator depending on a movement variable of the locking body (40, 40') and/or an application of force to the locking body (40, 40').

15. Method for switching a switch comprising a switching device according to one of the preceding claims, in which the switch has the at least one switching contact (60) of the switching device (10).

16. Method according to one of the preceding claims, in which a switch with at least two or more phases is switched and the switch has at least one switching contact of the switching device (10) for each phase.

## Revendications

1. Dispositif de coupure, comprenant au moins un contact (60) de coupure électrique ainsi qu'un dispositif (AE) actionneur constitué pour le serrage et ayant un actionneur (130) à corps solide et un groupe (120) hydraulique monté mécaniquement en série avec l'actionneur (130) à corps solide, dans lequel le groupe (120) hydraulique a un volume hydraulique, qui est rempli d'un liquide (195) hydraulique, dans lequel le dispositif de coupure a en outre un corps (40) d'arrêt, qui peut être arrêté par le dispositif actionneur et qui est couplé en déplacement avec le au moins un contact (60) de coupure électrique,
**caractérisé en ce que**
le corps d'arrêt est un corps (40) de serrage, qui peut être serré au moyen du groupe (120) hydraulique, et/ou un corps (40') à complémentarité de forme, qui peut être fixé à complémentarité de forme au moyen du groupe (120) hydraulique.

2. Dispositif de coupure suivant la revendication précédente, qui a un élément (20) de ressort et/ou un élément d'entraînement, qui est disposé et constitué pour appliquer une force au corps (40) d'arrêt et/ou pour entraîner le corps (40) d'arrêt, en étant notamment disposé et constitué sur le corps (40) d'arrêt.

3. Dispositif de coupure suivant l'une des revendications précédentes, dans lequel l'élément (20) de ressort ou l'élément d'entraînement a un accumulateur de pression et/ou un aimant.

4. Dispositif de coupure suivant l'une des revendications précédentes, dans lequel le dispositif actionneur a au moins une surface (100) de serrage, qui est constituée pour la mise en prise à frottement du corps (40) d'arrêt constitué en corps de serrage et/ou a une saillie (100') et/ou un évidement, qui est constitué pour la mise en prise à complémentarité de forme du corps (40') d'arrêt constitué en corps à complémentarité de forme ou qui est constitué en ayant le corps (40') d'arrêt constitué en corps à complémentarité de forme.

5. Dispositif de coupure suivant l'une des revendications précédentes, dans lequel le dispositif actionneur est constitué pour serrer le pourtour, de préférence tout le pourtour du corps (40) de serrage.

6. Dispositif de coupure suivant l'une des revendications précédentes, dans lequel le liquide (195) hydraulique est ou a un métal liquide, notamment du galium, de l'indium, de l'étain et/ou du mercure et/ou un alliage eutectique et/ou un liquide (195) hydraulique, qui est liquide à une pression normale à une température de 20°C, de préférence à 0°C, et de façon idéale à - 20°C et/ou à une température de fonctionnement et à une pression de fonctionnement du dispositif de coupure.

7. Dispositif de coupure suivant l'une des revendications précédentes, dans lequel le groupe (120) hydraulique est constitué pour transmettre un mouvement à partir de l'actionneur (130) à corps solide avec un rapport de démultiplication différent de un, à un élément (100) à déplacer, notamment à une mâchoire de serrage, constituée pour le serrage du corps (40) de serrage, et/ou à un élément (100') à complémentarité de forme constitué pour la fixation à complémentarité de forme du corps (40') à complémentarité de forme.

8. Dispositif de coupure suivant l'une des revendications précédentes, dans lequel le groupe (120) hydraulique a au moins une chambre (140) d'entrée, une chambre (230) de sortie et de préférence un conduit (235) hydraulique mettant cette chambre (140) d'entrée en communication avec la chambre (230) de sortie.

9. Dispositif de coupure suivant l'une des revendications précédentes, dans lequel le groupe (120) hydraulique a au moins un élément (160) d'entraînement, qui délimite en partie la chambre (140) d'entrée et qui peut être déplacé au moyen de l'actionneur (130) à corps solide, dans lequel, par le déplacement de l'élément (160) d'entraînement, un écoulement du liquide (195) hydraulique entre la chambre (140) d'entrée et la chambre (230) de sortie, notamment de la chambre (140) de sortie à la chambre (230) d'entrée, et/ou une diminution de la pression dans la chambre (140) de sortie peut être provoqué.

10. Dispositif de coupure suivant l'une des revendications précédentes, dans lequel le groupe (120) hydraulique a en outre une chambre (210) formant réservoir du liquide (195) hydraulique, de préférence soumise à une pression.

11. Dispositif de coupure suivant l'une des revendications précédentes, au moins suivant les revendications 8 et 10, dans lequel la chambre (210) formant réservoir est soumise à une pression et dans lequel la chambre (210) formant réservoir soumise à une pression est constituée et reliée hydrauliquement pour l'application d'une pression à la chambre (230) de sortie, notamment au moyen de l'application d'une pression à la chambre (140) d'entrée.

12. Dispositif de coupure suivant l'une des revendications précédentes, dans lequel l'actionneur (130) à corps solide est constitué sous la forme ou avec un actionneur piézoélectrique et/ou un actionneur à empilement piézoélectrique et/ou est un actionneur magnétostrictif ou un actionneur électrostrictif et/ou un actionneur à mémoire de forme ou a un actionneur de ce genre.

13. Dispositif de coupure suivant l'une des revendications précédentes, dans lequel le dispositif actionneur a au moins deux corps (40, 40') d'arrêt, qui sont accouplés en déplacement à respectivement au moins un contact de coupure électrique.

14. Dispositif de coupure suivant l'une des revendications précédentes, dans lequel il y a un dispositif de commande, qui est conçu pour commander l'actionneur à corps solide en fonction d'une amplitude de déplacement du corps (40, 40') d'arrêt et/ou d'une force appliquée au corps (40, 40') d'arrêt.

15. Procédé de manœuvre d'un interrupteur ayant un dispositif de coupure suivant l'une des revendications précédentes, dans lequel l'interrupteur a le au moins un contact (60) de coupure du dispositif (10) de coupure.

16. Procédé suivant l'une des revendications précédentes, dans lequel on manœuvre un interrupteur ayant au moins deux ou plusieurs phases et l'interrupteur a, par phase, au moins un contact de coupure du dispositif (10) de coupure.
